# EUROPEAN PATENT APPLICATION

(11) **EP 4 484 970 A1**
(43) Date of publication of application: **01.01.2025**
(21) Application number: 23760135.6
(22) Date of filing: 25.02.2023
(51) Int. Cl.: G01R 27/02, G01R 31/389

(54) **IMPEDANCE MEASUREMENT DEVICE, MEASUREMENT METHOD, AND SECONDARY BATTERY DIAGNOSIS SYSTEM**

(30) Priority: 27.02.2022 JP 2022028753
(71) Applicant: denchi, Inc., Honjo-shi, Saitama 367-0035 (JP)
(72) Inventor: MUKOYAMA, Daikichi, Honjo-shi, Saitama 367-0035 (JP); MUKOYAMA, Koichi, Honjo-shi, Saitama 367-0035 (JP); INOUE, Kazutaka, Honjo-shi, Saitama 367-0035 (JP)
(74) Representative: Rösler Rasch van der Heide & Partner
(86) International application number: PCT/JP2023/006891
(87) International publication number: WO 2023/163137

(57) **Abstract**

The invention improves an accuracy of an impedance analysis used for a battery condition diagnosis, and so on. An impedance measurement device comprises: an applicator that applies a voltage or a current consisting of a staircase wave with 3 or more steps to any electrochemical system as an input signal; a measurer that measures a voltage input value or a current input value of the input signal and a current response value or a voltage response value corresponding to the input signal as a response signal; and a calculator that calculates impedance values at plural frequencies from the current response value or the voltage response value of the response signal.

## Description

### BACKGROUND OF THE INVENTION

### [Field of the Invention]

The present invention provides an impedance measurement device and measurement method that can acquire impedance values at more frequencies in a simple configuration and shorter time, and a secondary battery diagnosis system that can diagnose a condition of battery with high accuracy using the impedance measurement device.

### [Description of the Related Art]

Conventionally, lithium-ion batteries have been widely used as mobile power sources in smartphones and laptop computers. In recent years, as the lithium-ion batteries have become larger in capacity, they are also being used as in-vehicle power sources for electric vehicles and large storage batteries for power storage, making them more important than ever before to ensure durability and safety.

As a method for measuring a condition of such batteries, an AC impedance method is known, in which an AC sine wave is applied to the battery to obtain an impedance response. By analyzing an impedance measurement result using this method, the condition of an inside of the battery, for example, deterioration of electrodes and active materials, an electrolyte, and an electrolyte solution, can be learned in detail.

However, since charging and discharging of large secondary batteries for the electric vehicles and other vehicles is performed using direct current, the AC impedance method, in which the AC sine wave is applied to the battery, requires an expensive equipment and is difficult to control an input voltage, making it difficult to operate in practical terms. In contrast, the method has been developed to measure impedance by using a power controller with a simple configuration and applying square waves, which is a pseudo-pulse waveform, to the battery (see, for example, Patent Literature 1).

### [Related Art Literature]

### [Patent Literature]

[Patent Literature 1]
Japanese Unexamined Patent Application Publication No. 2014-126532.

### SUMMARY OF THE INVENTION

### [DISCLOSURE OF THE INVENTION]

### [PROBLEM TO BE SOLVED BY THE INVENTION]

In a conventional AC impedance method using a sine wave as an input signal, only an impedance value at a single frequency can be obtained in a single measurement. In contrast, according to the method of Patent Literature 1, which uses square waves, a response signal from the battery is Fourier transformed to obtain frequency components with odd multiples (1, 3, 5, 7, 9...) of a frequency of an input wave, thus enabling values at plural frequencies to be obtained in the single measurement. However, in order to diagnose the condition of the battery by an impedance analysis, a more detailed frequency-by-frequency impedance plot is desired. For example, when impedance values are plotted by the frequency using logarithmic frequency notation, only five values (1, 3, 5, 7, and 9) are available on a scale from 1 to 10 times a reference frequency, and obtaining more impedance values per unit time, especially in a low-frequency region, will further improve an analysis accuracy.

A purpose of the present invention is to obtain the impedance values at more frequencies by the simple configuration and the single measurement in an impedance measurement, thereby improving an accuracy of the impedance analysis used for battery condition diagnosis, and so on.

### [MEANS TO SOLVE THE PROBLEM]

In view of an above-mentioned issue of a conventional technology, the present inventors conducted intensive research and discovered that by applying an input signal consisting of a staircase wave with 3 or more steps of constant current or constant voltage to a battery, impedance values at more frequencies can be obtained in a single measurement, thereby improving an analysis accuracy using an impedance measurement, which led to a completion of the present invention. Therefore, the present invention is characterized by a use of the staircase wave with 3 or more steps as the input signals in the impedance measurement.

In other words, an impedance measurement device of the present invention comprises an applicator that applies a voltage or a current consisting of a staircase wave with 3 or more steps to any electrochemical system as an input signal, a measurer that measures a voltage input value or a current input value of the input signal and a current response value or a voltage response value corresponding to the input signal as a response signal, and a calculator that calculates impedance values at plural frequencies from the current response value or the voltage response value of the response signal.

An impedance measurement method of the present invention comprises an applying step that applies a voltage or current consisting of a staircase wave with 3 or more steps to any electrochemical system as an input signal, a measuring step that measures a voltage input value or a current input value of the input signal and a current response value or a voltage response value corresponding to the input signal as a response signal, and a calculating step that calculates impedance values at plural frequencies from the current response value or the voltage response value of the response signal.

Preferably, the input signal is the voltage or the current consisting of the staircase wave with 3 to 5 steps. It is also preferable that the input signal is the staircase wave obtained by superimposing two or more square waves of different frequencies. It is also preferable that the input signal is the staircase wave obtained by superimposing two or more square waves of the different frequencies and amplitudes. It is also preferable that the input signal is the staircase wave obtained by superimposing two or more square waves of the different frequencies with their phases shifted from each other. It is also preferable that the input signal is the staircase wave that is not a pseudo-sine wave.

Preferably, the input signal is the staircase wave obtained by superimposing one or two or more square waves whose frequency is (n+1)/n (n is an integer from 1 to 5) times a reference square wave on the reference square wave. Preferably, the input signal is the staircase wave obtained by superimposing one or two or more square waves whose frequency is (n+1)/n (n is an integer from 1 to 5) times the reference square wave and the amplitude is n/(n+1) (n is an integer from 1 to 5) times or less the reference square wave on the reference square wave. Preferably, the input signal is the staircase wave obtained by superimposing one or two or more square waves whose frequency is (n+1)/n (n is an integer from 1 to 5) times the reference square wave, with a phase shift of 10 to 350° relative to the reference square wave on the reference square wave.

A battery diagnosis device of the present invention comprises the impedance measurement device. A battery diagnosis method of the present invention comprises the impedance measurement method.

A secondary battery diagnosis system of the present invention comprises a connector conforming to a charge/discharge standard of a secondary battery to be measured, an applicator that applies a voltage or a current consisting of a staircase wave with 3 or more steps to the secondary battery to be measured as an input signal, a measurer that measures a voltage input value or a current input value of the input signal and a current response value or a voltage response value corresponding to the input signal as a response signal, a calculator that calculates impedance values at plural frequencies from the current response value or the voltage response value of the response signal, an analyzer that analyzes a degradation condition of a battery based on the impedance values, and a memory that stores the input signal and the response signal obtained by the measurer, the impedance value obtained by the calculator, and/or an analysis result of the degradation condition obtained by the analyzer.

It is also preferable that the applicator, the measurer, the calculator, the analyzer, and the memory can communicate with each other via a network. It is also preferable to further comprise a portable terminal that is capable of communicating via the network. It is also preferable to apply the staircase wave with 3 or more steps as the input signal to the secondary battery to be measured as a discharge voltage or a discharge current of the secondary battery in the measurer. It is also preferable to comprise a charging facility that can be connected to the secondary battery to be measured and the applicator via the connector, and to apply the staircase wave with 3 or more steps as the input signal to the secondary battery to be measured as a charging voltage or a charging current to the secondary battery in the measurer.

### [ADVANTAGE OF THE PRESENT INVENTION]

According to the present invention, it is possible to obtain the impedance values at more frequencies with a simple configuration and with a single measurement, thereby improving an accuracy of an impedance analysis used for battery condition diagnosis and other applications.

### BRIEF DESCRIPTION OF THE DRAWINGS

Fig. 1 is a schematic diagram of an impedance measurement device of the present invention.
Fig. 2 are examples of staircase waves with 2 to 4 steps (A: 2 steps, B: 3 steps, C: 4 steps).
Fig. 3 is the example of the staircase wave with 3 steps obtained by superimposing phase-shifted square waves.
Fig. 4 are plots of frequencies at which impedance values can be obtained for each of the staircase waves with 2 to 4 steps (A: 2 steps, B: 3 steps, and C: 4 steps).
Fig. 5 is a Nyquist diagram of a battery measured by the staircase wave with 2 to 4 steps.
Fig. 6 is a frequency response diagram of the battery measured by the staircase wave with 2 to 4 steps.
Fig. 7 is the schematic diagram of a secondary battery diagnosis system of the present invention.
Fig. 8 is a secondary battery diagnosis system of a first embodiment of the present invention.
Fig. 9 is a secondary battery diagnosis system of a second embodiment of the present invention.

### DETAILED DESCRIPTION OF THE INVENTION

### Impedance measurement device

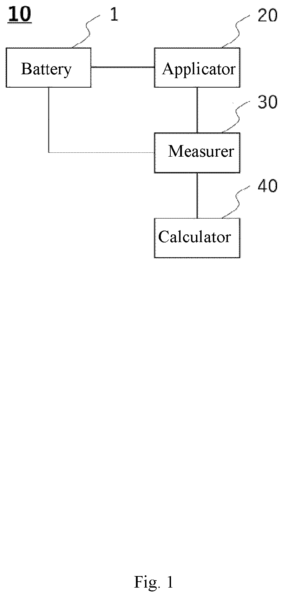

A schematic diagram of an impedance measurement device of the present invention is illustrated in Fig. 1.

As illustrated in Fig. 1, an impedance measurement device 10 of the present invention comprises an applicator 20, a measurer 30, and a calculator 40. An impedance in the present invention is not limited to those that satisfy constancy in the narrow sense, but also includes the impedance that changes over time, such as in situ impedance

A battery 1 to be measured is connected to the applicator 20 and the measurer 30, respectively. Although the battery is used as an object to be measured in this example, any other electrochemical system is acceptable, such as electrochemical cells, capacitors, speakers, and other electrical appliances. Batteries, whether primary or secondary, include, for example, lithium-ion batteries, nickel-metal hydride batteries, lead-acid batteries, and nickel-cadmium batteries. The present invention is particularly useful in measuring the impedance of large automotive batteries and large storage batteries, or in diagnosing a condition of the batteries based on such measurements.

The applicator 20 is connected to the battery 1 and applies a voltage or current consisting of a staircase wave with 3 or more steps to the battery 1 as an input signal. The measurer 30 is connected to the battery 1 and the applicator 20, and measures a voltage input value or a current input value of the input signal from the applicator 20 and a current response value or a voltage response value of the battery 1 corresponding to the input signal from the applicator 20. When observing a response at a constant voltage, the applicator 20 applies a voltage value controlled to be the staircase wave of 3 or more steps to the battery 1 as the input signal, and measurer 30 measures a change in a current value as its response signal. Alternatively, when observing the response at a constant current, the applicator 20 applies the current value controlled to be the staircase wave of 3 or more steps to the battery 1 as the input signal and measurer 30 measures the change in the voltage value as its response signal. Therefore, the applicator 20 is required to control the input signal to become a predetermined voltage value or current value. For example, the input signal can be adjusted to become the constant current or the constant voltage by using a power controller provided in a charging/discharging facility of the battery to be measured.

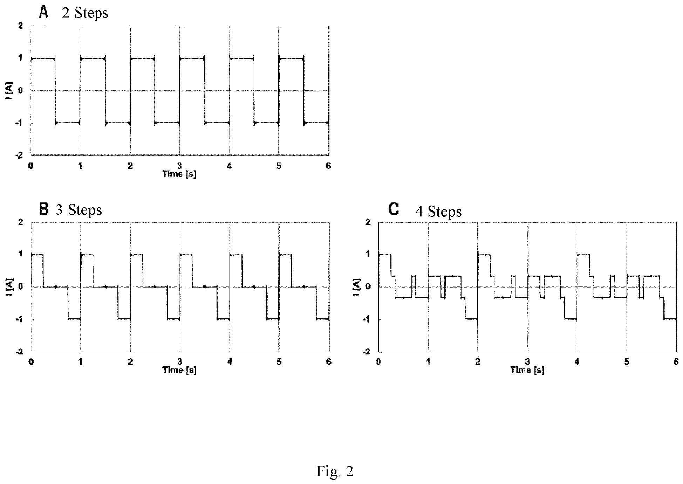

Fig. 2 illustrates examples of staircase waves for each number of steps from 2 to 4.

In the present invention, the staircase wave is a waveform in which the voltage value or the current value varies stepwise (staircase-like) with respect to time. Number of steps of the staircase wave means the number of stationary portions (linear portions) of the voltage value or the current value per cycle (see, for example, JP-A-2007-266951). Therefore, a 1-step staircase wave is a signal controlled to have a constant voltage value or current value, and the waveform is a single straight line. A 2-step staircase wave has two stationary portions of the voltage value or the current values per cycle, and is a pseudo-pulse waveform comprising of high and low-levels switched on and off as illustrated in Fig. 2A, and is generally called a square wave. In other words, it is the waveform configured with a substantially linear transition between a high-level stationary portion and a low-level stationary portion, and a typical square wave is usually a 1:1 ratio of high and low-level times (duty ratio). The smaller the ratio of the higher levels, the closer to a typical pulse wave. In the technique described in the patent literature 1, an impedance measurement is performed using this 2-step staircase wave (square wave), which is the pseudo-pulse waveform.

In the impedance measurement device of the present invention, the staircase wave with 3 or more steps is used as the input signal. Figs. 2B and 2C illustrate examples of 3-step and 4-step staircase waves. The 3-step staircase wave is the signal with 3 stationary portions (hereinafter referred to as "steps") of the voltage value or the current value per cycle. The 4-step staircase wave is the signal with 4-steps per cycle. The waveforms of these staircase waves also have the substantially linear transition between the stationary portions.

The 3-step staircase wave is obtained by superimposing 2-step staircase waves of different frequencies, i.e., two square waves. In other words, the 3-step staircase wave can be obtained by superimposing the square wave of a different frequency on a single reference square wave. The 3-step staircase wave illustrated in Fig. 2B is obtained by superimposing the square wave of twice the frequency on the reference square wave.

The 4-step staircase wave is obtained by superimposing three square waves of the different frequencies. The 4-step staircase wave illustrated in Fig. 2C is obtained by superimposing three square waves: one with 3/2 times the frequency and the other with twice the frequency, on the reference square wave. Here, the number of steps of the staircase wave means the number of stationary portions (linear portions) of the voltage value or the current value per cycle, but the number of stationary portions appearing multiple times at a same absolute value is counted as one. In other words, the staircase wave in Fig. 2C has 4 steps since the stationary portion appears at four positions of +1A, +0.33A, -0.33 A, and -1A as absolute values.

As with the 3-step and 4-step staircase waves described above, a 5-step or higher staircase wave is obtained by superimposing four or more square waves of the different frequencies. In other words, the 5-step staircase wave is obtained by superimposing four square waves, and a 6-step staircase wave is obtained by superimposing five square waves. In the present invention, it is preferable to use the staircase wave with 3 to 5 steps. The staircase wave with 6 or more steps may be difficult to control due to the complexity of the waveform. The frequency of the staircase wave used in the present invention is not limited, but it is preferable to adjust it to the frequency of 100 Hz or lower.

In the present invention, it is preferable to use the staircase wave obtained by superimposing one or two or more square waves whose frequency is (n+1)/n (n is an integer from 1 to 5) times the reference square wave on the reference square wave. In other words, the staircase wave obtained by superimposing one or two or more square waves whose frequency is 2 times, 3/2 times, 4/3 times, 5/4 times, or 6/5 times the reference square wave can be suitably used.

When the square wave with (n+1)/n times the frequency is superimposed on the reference square wave, the cycles overlap at n times a position. For example, when the square wave of twice the frequency is superimposed on the reference square wave, the cycle overlaps at the 1-fold position. Similarly, when the square wave of 3/2 times the frequency is superimposed on the reference square wave, the cycle overlaps at the 2-fold position, and when the square wave of 4/3 times the frequency is superimposed on the reference square wave, the cycle overlaps at the 3-fold position. Thus, by superimposing (n+1)/n times the square wave, the cycle overlaps at n-fold the position, which shortens the cycle as the staircase wave, making it easier to handle as the input wave and to analyze and process the response signal.

In designing the staircase wave for the present invention, an amplitude of a superimposed square wave may be the same as or different from the amplitude of the reference square wave. Specifically, it is also preferable that the amplitude of the superimposed square wave be less than or equal to the reciprocal of a multiple of the frequency. For example, if the square wave of twice the frequency is to be superimposed on the reference square wave, its amplitude is to be less than 1/2 times the amplitude of the reference square wave. Similarly, the amplitude is adjusted and superimposed such that, the square wave with the frequency of 3/2 times is superimposed with the amplitude of 2/3 times or less, the square wave with the frequency of 4/3 times is superimposed with the amplitude of 3/4 times or less, and the square wave with the frequency of 5/4 times is superimposed with the amplitude of 4/5 times or less, and so on. In other words, when the square wave with (n+1)/n times the frequency of the reference square wave is superimposed, the amplitude is preferably n/(n+1) times or less.

The staircase wave with 3 or more steps illustrated in Figs. 2B and 2C are good examples of the input signals used in the present invention.

The staircase wave in Fig. 2B has 3 steps and is obtained by superimposing the square wave with the frequency doubled (same amplitude) on the reference square wave. This staircase wave has the cycle of 1.0 second, a reference is 0A, a first step is +1A, a second step is 0A, and a third step is -1A.

The staircase wave in Fig. 2C has 4 steps, and is obtained by superimposing the square wave with the frequency doubled and the amplitude multiplied by 1/2, and the square wave with the frequency multiplied by 3/2 and the amplitude multiplied by 2/3, with respect to the reference square wave. This staircase wave has the cycle of 2.0 seconds, the reference is 0A, the first step is +1A, the second step is +0.33 A, the third step is -0.33 A, and a fourth step is -1A.

The staircase waves illustrated in Figs. 2B and 2C are all positive-negative symmetrical waveforms with the reference being 0A, but the reference does not have to be 0A. For example, the waveform may have the reference +3 A, with +4A on a high-level side and +2A on a low-level side, or have the reference -3A, with -2A on the high-level side and -4A on the low-level side. In particular, when used for battery diagnosis, the measurement may be made with a charging or discharging current flowing through the battery, in which case the staircase wave may be designed with the reference set at any position on plus (+) side or minus (-) side.

Furthermore, in creating the staircase wave in the present invention, the square wave with a shifted phase may be used for the reference square wave or the superimposed square wave, or both, respectively. As illustrated in Fig. 2A, a normal square wave rises linearly to a stationary voltage value or a stationary current value as soon as it is input. When the phase of such square waves is shifted, the rise of the input signal is delayed by amount of the shifted phase, resulting in waveforms with the same shape but different cycles in time units. Therefore, a wider variety of the staircase waves can be created by superimposing square waves that are phase-shifted from each other.

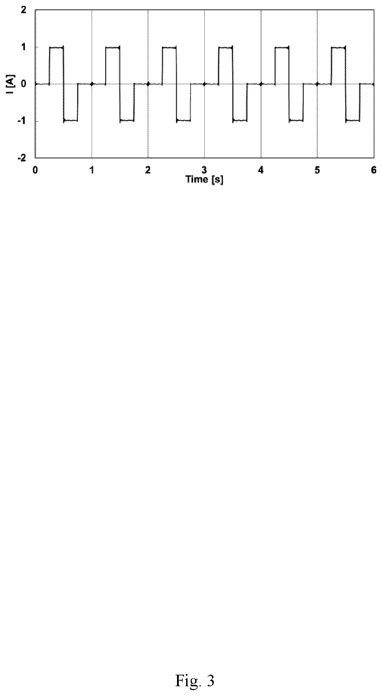

Fig. 3 illustrates the staircase wave obtained by superimposing a phase-shifted square wave with respect to the reference square wave. The 3-step staircase wave illustrated in Fig. 3 was obtained by superimposing the square wave with twice the frequency and 180° phase-shift on the reference square wave. The 3-step staircase wave obtained by superimposing the square wave of the same phase illustrated in Fig. 2B and the 3-step staircase wave obtained by superimposing phase-shifted square wave illustrated in Fig. 3 differ in a nature of the input signal change, even though they have similar shapes. Depending on a type of electrochemical system to be measured, especially the type and material of the battery, an appropriate staircase wave as the input signal to obtain a stable impedance value may vary in various ways. Therefore, it may be necessary to design the wider variety of the staircase waves for the impedance measurement.

When creating the staircase wave, the phase of the reference square wave may be shifted, or the phase of the superimposed square wave may be shifted. Alternatively, the phase of both the reference wave and the superimposed wave may be shifted. Since one cycle is 360°, the phase of the square wave should be shifted in a range of 0 < X < 360°. In particular, it is preferable to shift the phase of the square wave in the range of 10 to 350°.

As for the staircase wave used in the present invention, it is preferable that the waveform not be a pseudo-sine wave. In the field of electronics and signal processing, the waveform called the pseudo-sine wave, which is made by approximating a fine staircase waveform to a sine wave, is known and is sometimes used as an alternative waveform to an AC sine wave. On the other hand, if the AC sine wave is used in the impedance measurement, only an impedance value at one frequency can be obtained in a single measurement. Therefore, if such pseudo-sine wave is used as the staircase wave of the present invention, an effect of the present invention of obtaining the impedance values at more frequencies in the single measurement may not be achieved.

In the present invention, by using the staircase wave with 3 or more steps as the input signal, more impedance values can be obtained per unit time, especially in a low-frequency region, compared to a case of using the 2-step staircase wave (square wave) used in, for example, the patent literature 1.

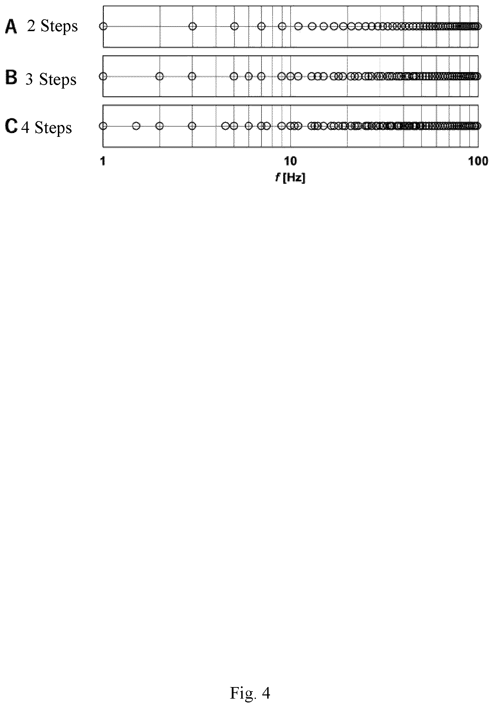

Fig. 4 illustrates plots of the frequencies at which the impedance values are obtained when the 2-step staircase wave (square wave) is used (Fig. 2A), when the 3-step staircase wave is used (Fig. 2B), and when the 4-step staircase wave is used (Fig. 2C). The results are the same whether the staircase wave in Fig. 2B or the staircase wave in Fig. 3 is used as the 3-step staircase wave.

By frequency analysis of the response signal from the battery, when the 2-step staircase wave (square wave) is used, odd multiples of the frequency of the staircase wave are obtained, and if the reference frequency is 1, 5 data points at 1, 3, 5, 7, and 9 times are obtained on a low frequency side ranging from 1 to 10 times. However, this number of data is not sufficient, especially on the low frequency side, and it is desirable to obtain more impedance values.

In contrast, when the 3-step staircase wave is used, more data can be obtained on the low frequency side ranging from 1 to 10 times the reference frequency, with 8 points at 1, 2, 3, 5, 6, 7, 9, and 10 times (note that the results are the same whether the staircase wave in Fig. 2B or Fig. 3 is used as the 3-step staircase wave). When the 4-step staircase wave is used, data can be obtained at 11 points at 1, 1.5, 2, 3, 4.5, 5, 6, 7, 7.5, 9, and 10 times the frequency, which is even finer.

The impedance value in the low-frequency region is very important, especially for a purpose of a battery impedance analysis. By using the impedance measurement device of the present invention, more data can be obtained in the low-frequency region, which can greatly improve an accuracy of a battery analysis. In addition, while a conventional AC impedance method using sine waves requires an expensive equipment such as a frequency analysis equipment, potentiostats, and so on, and has problems such as difficulty in controlling an input voltage, the impedance measurement device of the present invention enables analysis with a relatively simple configuration that controls any voltage/current values by time.

The measurer 30 is connected to the battery 1 and the applicator 20, and measures the voltage input value or the current input value of the input signal from the applicator 20, and the current response value or the voltage response value of the battery 1 corresponding to the input signal from the applicator 20. The measured input signal and the response signal are sent to the calculator 40 connected to the measurer 30, and the impedance values of the battery 1 at plural frequencies are calculated by performing frequency analysis such as Fourier transform, wavelet transform, and so on, on the input signal and the response signal in the calculator 40.

More specifically, the input signal from the applicator 20 and the response signal from the battery 1 are measured by the measurer 30, and an input spectrum and an output spectrum are obtained at the calculator 40. The impedance values Z' and Z" at the respective frequencies are then calculated by a cross-correlation function/autocorrelation function of these spectra.

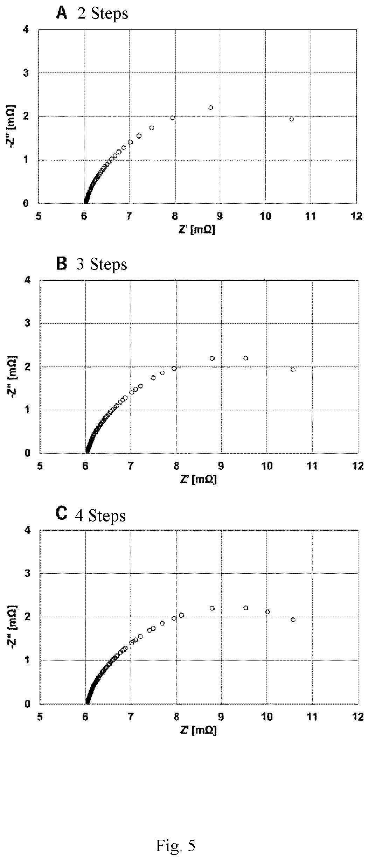

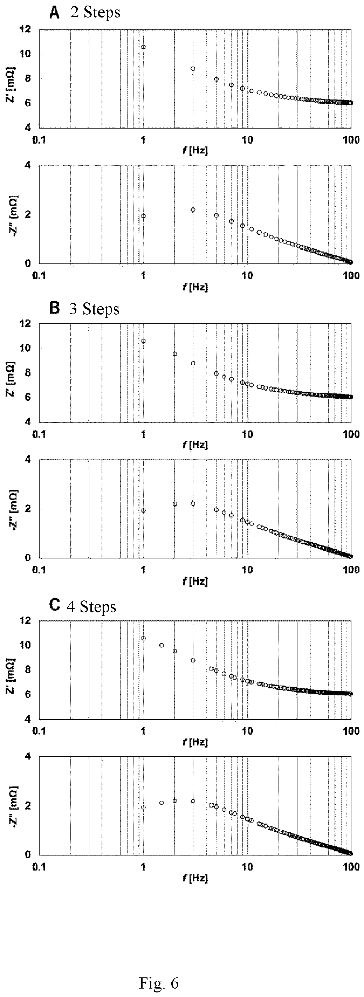

A Nyquist diagram of the impedance values calculated from an input-output spectrum obtained by inputting each of the staircase waves in Figs. 2A, 2B and 2C to the battery as the input signals (current input values) is illustrated in Fig. 5, and a frequency response diagram in Fig. 6.

As illustrated in Fig. 5A, an impedance data obtained using the 2-step staircase wave (square wave) has a small amount of data in the low-frequency region of 1 to 10 Hz, so a shape of a curve is somewhat unclear.

In comparison, the impedance data obtained using the 3-step staircase wave illustrated in Fig. 5B illustrates that the amount of data in the low-frequency region of 1 to 10 Hz has increased, and the shape of the curve is more clearly defined. In addition, the impedance data obtained using the 4-step staircase wave illustrated in Fig. 5C illustrates an even clearer curve in the low-frequency region.

For the purpose of battery condition diagnosis, it is important to read minute changes in impedance characteristics. For example, when multiple data from measured impedance values are compared as the Nyquist diagram, an increase in a diameter of a semicircle indicates the increase in internal resistance as well. However, if the plot of the impedance values per frequency is small, such minute changes cannot be read. In a highfrequency region (1 Hz or above), it is relatively easy to increase the data by increasing the number of measurements since a measurement time is shorter, but in the low-frequency region (below 1 Hz), it is not practical to increase the number of measurements since each measurement takes longer.

According to the method of patent literature 1, by using the 2-step staircase wave (square wave), the impedance values can be obtained at odd multiples (1, 3, 5, 7, 9, ... times) of the frequency of the input wave, so the data can be obtained in a relatively wide frequency region in the single measurement. However, as illustrated in Fig. 5A, the number of the data is not sufficient at low-frequencies. In contrast, as illustrated in Figs. 5B and 5C, the present invention uses the staircase wave with 3 or more steps to obtain more impedance data on the low-frequency side, which enables reading of even the minute changes in the impedance characteristics, thereby greatly improving the accuracy of impedance analysis.

### Secondary battery diagnosis system

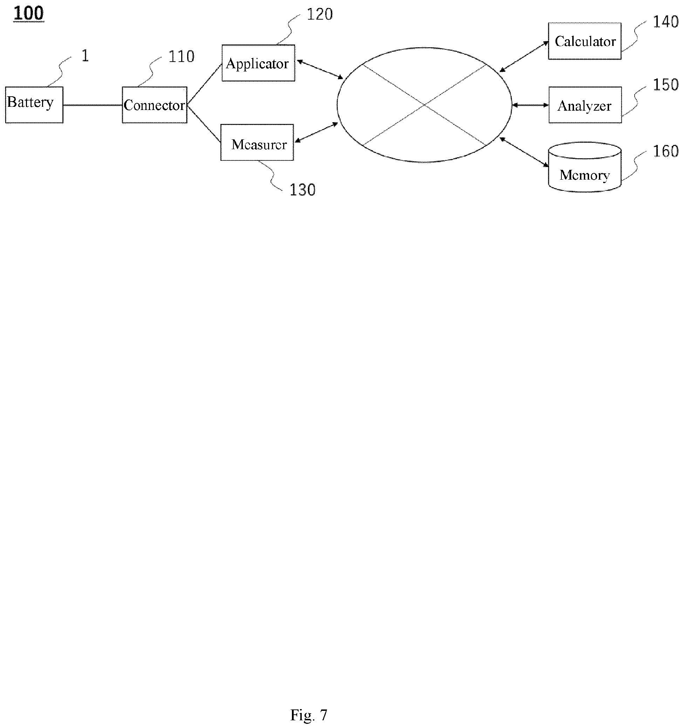

Fig. 7 illustrates the schematic diagram of a secondary battery diagnosis system of the present invention.

As illustrated in Fig. 7, the secondary battery diagnosis system 100 of the present invention comprises a secondary battery 1 to be measured, a connector 110, an applicator 120, a measurer 130, a calculator 140, an analyzer 150, and a memory 160. The secondary battery 1 to be measured is in communication with the applicator 120 and the measurer 130 via the connector 110. The applicator 120, the measurer 130, the calculator 140, the analyzer 150, and the memory 160 are in a state in which they can communicate with each other via a network.

The secondary battery 1 to be measured is the battery configured to be able to charge and discharge, such as lithium-ion batteries, nickel-metal hydride batteries, or lead-acid batteries. The present invention is particularly useful in diagnosis of automotive secondary batteries or large stationary storage batteries, but can also be used for other secondary batteries.

The connector 110 conforms to a charge/discharge standard of the secondary battery 1 to be measured. For example, the charge/discharge standards for electric vehicles include CHAdeMO, GB/T, CCS1, CCS2, Tesla, and so on. In other words, a charging connector that matches the charge/discharge standards of an inlet on the secondary battery 1 side is the connector 110. The connector 110 communicates with the applicator 120 and the measurer 130 via cables.

The applicator 120, the measurer 130, and the calculator 140 are roughly the same as the applicators and measurers of the impedance measurement device described above, and are briefly described below.

The applicator 120 communicates the secondary battery 1 to be measured via the connector 110 and applies the voltage or the current consisting of the staircase wave with 3 or more steps to the secondary battery 1 as the input signal. Here, the staircase wave with 3 or more steps is the waveform with 3 or more stationary portions of the voltage or the current values per cycle. The measurer 130 communicates with the secondary battery 1 and the applicator 120, and measures the voltage input value or the current input value of the input signal from the applicator 120 and the current response value or the voltage response value of the secondary battery 1 corresponding to the input signal from the applicator 120.

The input signal and the response signal measured in the measurer 130 are transmitted via the network to the calculator 140, and by performing frequency analysis such as Fourier transform and wavelet transform on the input signal and the response signal in the calculator 140, the impedance values of the secondary battery 1 at the plural frequencies are calculated.

Here, in the secondary battery diagnosis system of the present invention, by using the staircase wave with 3 or more steps as the input signal, the impedance values at more frequencies can be obtained in the single measurement compared to the conventional method. This makes it possible to read even the minute changes in impedance characteristics, greatly improving the accuracy of the impedance analysis.

Impedance value data calculated in the calculator 140 is transmitted via the network to the analyzer 150, where the analyzer 150 performs a predetermined analysis process to obtain detailed degradation information on the secondary battery 1. More specifically, for example, in the analyzer 150, the impedance value data obtained in the calculator 140 can be fitted using a predetermined equivalent circuit to obtain detailed analysis data.

Inside the battery, various processes occur, including electron transfer within electrode composite layer, between the composite layers of a current collector, and within the current collector; ion transfer in the separator, in a composite layer electrolyte, and at solid electrolyte interface (SEI); charge transfer by electrochemical reaction; and solid phase diffusion in an active material, and so on. In the impedance analysis, an equivalent circuit design is performed based on these elementary processes. Information on various elementary processes described above can be obtained by performing a fitting analysis on the impedance data obtained by measuring the secondary battery 1 using the predetermined equivalent circuit. The analysis data thus obtained is then transmitted via the network to the memory 160. If necessary, more detailed degradation information can be obtained by recalling the analysis data stored in the memory 160 and comparing the analysis data obtained between various batteries. In addition to such fitting analysis, the analyzer 150 may also perform various other analysis processes, such as history and temperature information.

The input signal and the response signal measured in the measurer 130, the impedance value data calculated in the calculator 140, and the analysis data obtained in the analyzer 150 are all transmitted to the memory 160 via the network and stored therein. If necessary, the data may also be transmitted from the memory 160 to a separately communication-capable connected terminal. For example, a PC, a smartphone, or other terminal equipped with an input device such as a keyboard, a mouse, or a touch panel can be operated to check the impedance value data and the analysis data from a terminal equipped with a display.

The measurer 130, the calculator 140, the analyzer 150, and the memory 160 may be stand-alone devices that are integrated into a single device and not connected to an external network. Alternatively, the input signal and the response signal obtained in the measurer 130 may be transmitted from a device, in which the measurer 130 is provided, to an external server via the network and processed in the calculator 140, the analyzer 150, and the memory 160 provided in the external server. In this case, calculation and analysis processes in the external server can be operated directly from a measurement device. Alternatively, the processing in the server can be operated from the terminal such as the PC or smart phone that is separately provided to communicate with the network.

### First Embodiment

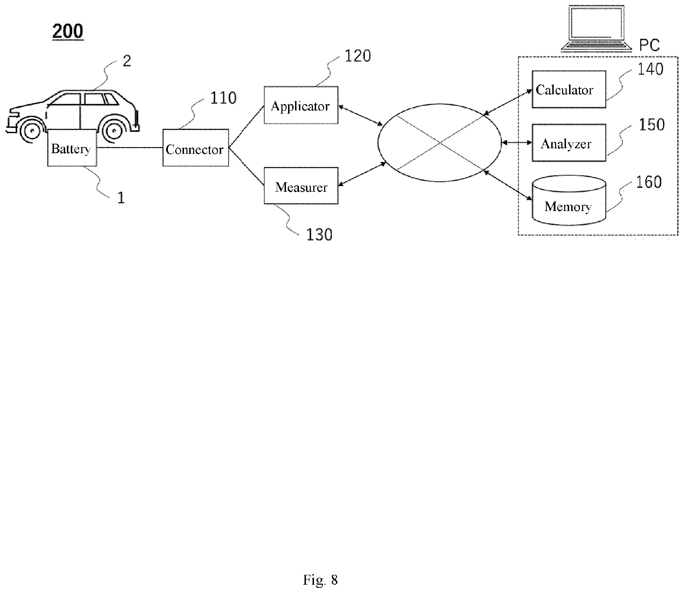

Fig. 8 illustrates a schematic diagram of a secondary battery diagnosis system 200 according to a first embodiment of the present invention. In the first embodiment of the secondary battery diagnosis system 200, an applicator 120 and a measurer 130 are connected to a secondary battery 1 installed in an electric vehicle 2 via a connector 110. On the other hand, a CPU, ROM, RAM, and external memory devices are mounted in a PC, which serve as a calculator 140, an analyzer 150, and a memory 160. The applicator 120 and the measurer 130 are connected to the PC in a state in which they can communicate with each other via communication such as a wired cable, wireless LAN, 5G, or Bluetooth, so that the applicator 120, the measurer 130, the calculator 140, the analyzer 150, and the memory 160 are in the state in which they can communicate with each other via a network.

In the secondary battery diagnosis system 200, all operations related to applications, measurements, calculations, and analysis can be performed from the PC via the network. For example, by calling up a control program stored in the external memory device of the PC and executing the program, it is possible to automatically perform all operations from the applications, measurements, calculations, and analysis, and display the analysis results on a display as diagnosis results of the secondary battery 1.

### Second Embodiment

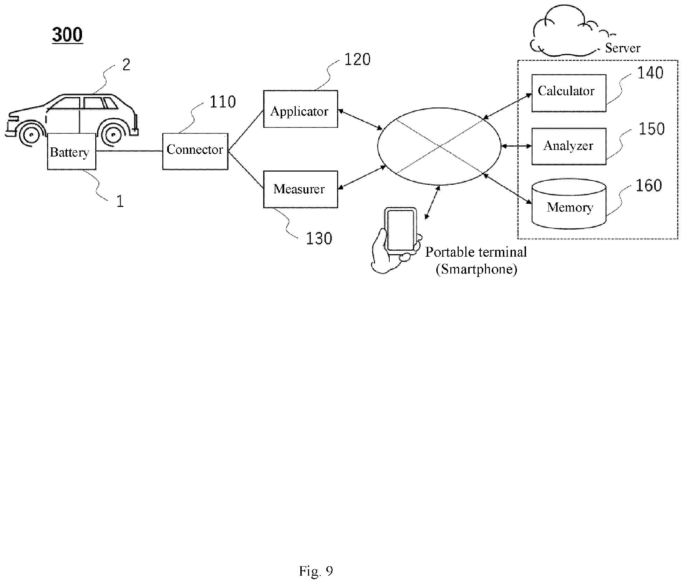

Fig. 9 illustrates a schematic diagram of a secondary battery diagnosis system 300 according to a second embodiment of the present invention. In the second embodiment of the secondary battery diagnosis system 300, as in the previous embodiment, an applicator 120 and a measurer 130 are connected to a secondary battery 1 mounted on an electric vehicle 2 via a connector 110. On the other hand, a calculator 140, an analyzer 150, and a memory 160 are installed on a server remotely located to the electric vehicle 2, and this server and the applicator 120 and the measurer 130 are in a state in which they can communicate with each other via the Internet. In addition, a portable terminal such as a smartphone is separately installed in the state that enables communication with the applicator 120, the measurer 130, and the server.

In the secondary battery system 300, software including various control programs is installed in the smartphone, which allows external operations ranging from applications, measurements, calculations, and analysis. Analysis results can be displayed on a smartphone screen as diagnosis results of the secondary battery 1, allowing battery diagnosis to be performed with very simple operations.

In the secondary battery diagnosis system of the present invention, in applying a voltage or a current consisting of a staircase wave with 3 or more steps to the secondary battery 1 as an input signal, the staircase wave with 3 or more steps may be applied directly as an AC signal, or as a DC signal such as a discharge current or a discharge voltage of the secondary battery, or a charge current or a charge voltage of the secondary battery. Rather, considering a supply stability of the input signal, a load on the secondary battery, and safety concerns, it is preferable to apply the staircase wave with 3 or more steps as the DC signal.

When the input signal is applied as the discharge voltage or the discharge current of the secondary battery, for example, by using an electronic load device, a waveform of the discharge voltage or the discharge current is controlled to be the staircase wave with 3 or more steps. In other words, although the staircase waves illustrated in Figs. 2B and 2C are the waveforms with 0 as a reference and range from +1A to -1A, when inputting the staircase wave as the discharge current, for example, it is required to adjust the waveform with -3A as the reference, with -2A on a high-level side and -4A on a low-level side. Although it is possible to set the high-level side to 0, it is preferable to at least adjust the input signal so that a current value is not 0, since it is sometimes difficult to handle a stable signal at a 0 level.

When the input signal is applied as the charging voltage or the charging current of the secondary battery, a charging facility that can be connected to the secondary battery to be measured and the applicator via a connector is required. Normally, charging of electric vehicles is performed by inserting a connecting connector of the charging facility into the connector of the secondary battery and applying the charging current. A DC charging current is a steady current of approximately constant amperage, and by superimposing the staircase wave with 3 or more steps on it, the staircase waves are applied to the secondary battery as the input signal.

### [Description of the reference numerals]

1: Object to be measured (battery)
10: Impedance measurement device
20: Applicator
30: Measurer
40: Calculator
100: Secondary battery diagnosis system
110: Connector
120: Applicator
130: Measurer
140: Calculator
150: Analyzer
160: Memory

## Claims

1. An impedance measurement device comprising:
an applicator that applies a voltage or a current consisting of a staircase wave with 3 or more steps to any electrochemical system as an input signal;
a measurer that measures a voltage input value or a current input value of the input signal and a current response value or a voltage response value corresponding to the input signal as a response signal; and
a calculator that calculates impedance values at plural frequencies from the current response value or the voltage response value of the response signal.

2. The impedance measurement device according to claim 1, wherein the input signal is the voltage or the current consisting of the staircase wave with 3 to 5 steps.

3. The impedance measurement device according to claim 1, wherein the input signal is the staircase wave obtained by superimposing two or more square waves with different frequencies.

4. The impedance measurement device according to claim 3, wherein the input signal is the staircase wave obtained by superimposing two or more square waves with the different frequencies and amplitudes.

5. The impedance measurement device according to claim 3, wherein the input signal is the staircase wave obtained by superimposing two or more square waves with the different frequencies with their phases shifted from each other.

6. The impedance measurement device according to claim 1, wherein the input signal is the staircase wave that is not a pseudo-sine wave.

7. The impedance measurement device according to claim 3, wherein the input signal is the staircase wave obtained by superimposing one or two or more square waves whose frequency is (n+1)/n (n is an integer from 1 to 5) times a reference square wave on the reference square wave.

8. The impedance measurement device according to claim 4, wherein the input signal is the staircase wave obtained by superimposing one or two or more square waves whose frequency is (n+1)/n (n is an integer from 1 to 5) times a reference square wave and the amplitude is n/(n+1) (n is an integer from 1 to 5) times or less the reference square wave on the reference square wave.

9. The impedance measurement device according to claim 5, wherein the input signal is the staircase wave obtained by superimposing one or two or more square waves whose frequency is (n+1)/n (n is an integer from 1 to 5) times a reference square wave, with a phase shift of 10 to 350° relative to the reference square wave on the reference square wave.

10. An impedance measurement method comprising:
an applying step that applies a voltage or current consisting of a staircase wave with 3 or more steps to any electrochemical system as an input signal;
a measuring step that measures a voltage input value or a current input value of the input signal and a current response value or a voltage response value corresponding to the input signal as a response signal; and
a calculating step that calculates impedance values at plural frequencies from the current response value or the voltage response value of the response signal.

11. The impedance measurement method according to claim 10, wherein the input signal is the voltage or the current consisting of a staircase wave with 3 to 5 steps.

12. The impedance measurement method according to claim 10, wherein the input signal is the staircase wave obtained by superimposing two or more square waves with different frequencies.

13. The impedance measurement method according to claim 12, wherein the input signal is the staircase wave obtained by superimposing two or more square waves with the different frequencies and amplitudes.

14. The impedance measurement method according to claim 12, wherein the input signal is the staircase wave obtained by superimposing two or more square waves with the different frequencies with their phases shifted from each other.

15. The impedance measurement method according to claim 10, wherein the input signal is the staircase wave that is not a pseudo-sine wave.

16. The impedance measurement method according to claim 12, wherein the input signal is the staircase wave obtained by superimposing one or two or more square waves whose frequency is (n+1)/n (n is an integer from 1 to 5) times a reference square wave on the reference square wave.

17. The impedance measurement method according to claim 13, wherein the input signal is the staircase wave obtained by superimposing one or two or more square waves whose frequency is (n+1)/n (n is an integer from 1 to 5) times a reference square wave and the amplitude is n/(n+1) (n is an integer from 1 to 5) times or less the reference square wave on the reference square wave.

18. The impedance measurement method according to claim 14, wherein the input signal is the staircase wave obtained by superimposing one or two or more square waves whose frequency is (n+1)/n (n is an integer from 1 to 5) times a reference square wave, with a phase shift of 10 to 350° relative to the reference square wave on the reference square wave.

19. A battery diagnosis device comprising an impedance measurement device according to claims 1 to 9.

20. A battery diagnosis method comprising an impedance measurement method according to claims 10 to 18.

21. A secondary battery diagnosis system comprising:
a connector conforming to a charge/discharge standard of a secondary battery to be measured;
an applicator that applies a voltage or a current consisting of a staircase wave with 3 or more steps to the secondary battery to be measured as an input signal;
a measurer that measures a voltage input value or a current input value of the input signal and a current response value or a voltage response value corresponding to the input signal as a response signal;
a calculator that calculates impedance values at plural frequencies from the current response value or the voltage response value of the response signal;
an analyzer that analyzes a degradation condition of a battery based on the impedance values; and
a memory that stores the input signal and the response signal obtained by the measurer, the impedance value obtained by the calculator, and/or an analysis result of the degradation condition obtained by the analyzer.

22. The secondary battery diagnosis system according to claim 21, wherein the applicator, the measurer, the calculator, the analyzer, and the memory can communicate with each other via a network.

23. The secondary battery diagnosis system according to claim 22, further comprising a portable terminal capable of communicating via the network.

24. The secondary battery diagnosis system according to claim 21, wherein in the measurer, the staircase wave with 3 or more steps are applied as the input signal to the secondary battery to be measured as a discharge voltage or a discharge current of the secondary battery.

25. The secondary battery diagnosis system according to claim 21, comprising a charging facility that can be connected to the secondary battery to be measured and the applicator via the connector, wherein in the measurer, the staircase wave with 3 or more steps are applied as the input signal to the secondary battery to be measured as a charging voltage or a charging current to the secondary battery.
